Europäisches Patentamt

(19) European Patent Office

Office européen des brevets

(11) Numéro de publication: **0 120 756**
**B1**

(12) **FASCICULE DE BREVET EUROPEEN**

(45) Date de publication du fascicule du brevet:
22.06.88

(51) Int. Cl.⁴: **H 03 F 3/191, H 03 B 5/36**

(21) Numéro de dépôt: **84400475.4**

(22) Date de dépôt: **09.03.84**

(54) Oscillateur comprenant un amplificateur passe-bande haute-fréquence à impédance adaptable.

(30) Priorité: **18.03.83 FR 8304485**

(43) Date de publication de la demande:
**03.10.84 Bulletin 84/40**

(45) Mention de la délivrance du brevet:
**22.06.88 Bulletin 88/25**

(84) Etats contractants désignés:
**DE GB NL**

(56) Documents cités:
FR - A - 1 469 614
FR - A - 2 145 990
US - A - 2 825 813
US - A - 3 375 466

ELEKTRO, vol. 2, no. 7-8, juillet-août 1976, page 723,
Elektro Publishers Ltd., Canterbury, GB; "Aerial
booster"
Handbook of Semiconductor Electronics, Lloyds P.
Huter, third edition, McGraw Hill book Company, pages
14-22 et 14-23.

(73) Titulaire: **COMPAGNIE D'ELECTRONIQUE ET DE
PIEZO-ELECTRICITE - C.E.P.E., 44, rue de la Glacière,
F-95100 Argenteuil (FR)**

(72) Inventeur: **Chauvin, Jacques, THOMSON-CSF
SCPI 173, bld Haussmann, F-75379 Paris Cedex 08 (FR)**
Inventeur: **Molle, Roger, THOMSON-CSF SCPI 173, bld
Haussmann, F-75379 Paris Cedex 08 (FR)**

(74) Mandataire: **Ruellan-Lemonnier, Brigitte et al,
THOMSON-CSF SCPI 19, avenue de Messine,
F-75008 Paris (FR)**

## Description

La présente invention a pour objet un oscillateur comprenant un amplificateur passe-bande haute-fréquence à impédance adaptable.

Les amplificateurs passe-bande haute-fréquence connus présentent en général des impédances d'entrée et de sortie élevées (de l'ordre de quelques milliers d'ohms) qui les rend sensibles aux dérives thermiques des semi-conducteurs qu'ils comportent.

D'autre part, les amplificateurs utilisés pour réaliser des oscillateurs haute-fréquence (notamment dans les montages du type Hartley) présentent également des impédances d'entrée et de sortie du même ordre de grandeur. Ces impédances élevées ont pour inconvénient de dégrader le facteur de qualité Q du résonateur que comporte l'oscillateur. Un tel oscillateur a alors une fréquence caractéristique moins table qu'elle pourrait l'être.

On connaît du «Handbook of Semiconductor Electronics, Lloyds P. Hunter, third edition, McGraw-Hill Book Company», pages 14–22 et 1–23 un oscillateur comportant un amplificateur passe-bande et un résonateur branché entre l'entrée et la sortie de l'amplificateur. Cet amplificateur comporte un transistor monté en base commune dont l'émetteur est chargé par un pont résistif dont le point milieu constitue l'entrée de l'amplificateur, le collecteur étant chargé par un circuit parallèle du type LC.

La présente invention a pour objet un oscillateur comprenant un amplificateur passe-bande haute-fréquence dont l'impédance est adaptable et qui peut notamment présenter des impédances d'entrée et de sortie de valeurs faibles.

Un tel amplificateur convient pour réaliser des oscillateurs étant donné que le impédances d'entrée et de sortie peuvent être faibles ce qui évite la dégradation du facteur de qualité Q du résonateur. D'autre part, un tel amplificateur convient également à l'amplification des signaux délivrés par un oscillateur, notamment un oscillateur selon l'invention à basse impédance de sortie.

L'invention concerne ainsi un oscillateur du type comportant un amplificateur passe-bande et un résonateur branché entre l'entrée et la sortie de l'amplificateur, l'amplificateur comportant un transistor monté en base commune, l'émetteur de ce transistor étant chargé par un pont résistif dont le point milieu constitue l'entré dudit amplificateur, le collecteur de ce transistor étant chargé par un circuit parallèle du type LC dont une extrémité est à la tension d'alimentation, caractérisé en ce qu'il peut fonctionner jusqu'à une fréquence de l'ordre de 500 MHz, l'amplificateur étant réglé de manière que la fonction de transfert en boucle ouverte remplisse les conditions de Berkhausen uniquement pour le pic de résonance du résonateur correspondant à la fréquence de résonance choisie, une résistance d'amortissement reliant le collecteur du transistor audit circuit parallèle, une résistance de base étant branchée entre la base du transistor et un condensateur destiné à assurer le fonctionnement en base commune, la première résistance et la seconde résistance dudit pont résistif ainsi que les résistances de base et d'amortissement ayant des valeurs déterminées de façon à empêcher la résistance d'entrée de l'oscillateur de devenir négative et en fonction des résistances d'entrée et de sortie désirées pour l'amplificateur.

Le transistor est d'un type présentant une caractéristique à résistance négative en fonctionnement en base commune et il présente une résistance de base de valeur suffisante pour la compenser, de telle sorte que l'on évite ainsi l'auto-oscillation de l'amplificateur.

Selon une variante, la première résistance du pont diviseur résistif est choisie de telle sorte que l'amplificateur présente une basse impédance d'entrée.

L'impédance capacitive ou selfique située entre au moins une sortie de l'amplificateur et la masse peut être choisie de telle sorte que l'amplificateur ait une basse impédance de sortie.

La fréquence de résonance du circuit parallèle est égale à une fréquence choisie du résonateur et l'amplificateur est réglé de manière telle que la fonction de transfert en boucle ouverte remplit les conditions de Berkhausen uniquement pour le pic de résonance du résonateur correspondant à la fréquence choisie. Les impédances d'entrée et de sortie de l'amplificateur sont de préférence au plus égales à la résistance série intrinsèque du résonateur, ceci afin d'éviter de dégrader le facteur de qualité intrinsèque du résonateur. En pratique, on essaiera d'obtenir les impédances d'entrée et de sortie les plus faibles compatibles avec la condition de gain définie ci-desus.

Selon une variante, un condensateur est branché aux bornes de la deuxième résistance du pont diviseur. Ce condensateur peut être utilisé en cas de gain insuffisant de l'amplificateur.

On peut avantageusement relier la première résistance du pont diviseur à la masse par un condensateur de découplage aux bornes duquel est disposée une troisième résistance permettant de diminuer la puissance consommée.

Une des sorties de l'amplificateur peut être reliée à un circuit d'amplification présentant une impédance adaptée, par exemple un amplificateur de sortie associé à un quadripôle dont l'entrée est reliée à ladite sortie de l'amplificateur et la sortie à l'entrée de l'amplificateur de sortie présentant une impédance d'entrée adaptée à l'impédance de ladite sortie de l'amplificateur et une impédance de sortie adaptée à l'impédance d'entrée de l'amplificateur de sortie. En particulier, le circuit d'amplification peut être constitué par au moins un amplificateur selon l'invention.

L'invention sera mieux comprise à la lecture de la description ci-dessous donnée à titre d'exemple non limitatif, en liaison avec les figures qui représentent:

– la figure 1, un schéma d'un oscillateur selon l'invention;

– la figure 2, un schéma électrique équivalent d'un résonateur monté dans un oscillateur;

– la figure 3, la fonction de transfert d'un amplificateur passe-bande;

– la figure 4, la fonction de transfert en boucle ouverte d'un oscillateur suivant l'invention;

– la figure 5, un schéma illustrant la condition de Berkhausen;

– la figure 6, un oscillateur à 5 mégahertz suivant l'invention associé à deux étages d'amplification;

– la figure 7, un oscillateur à 500 mégahertz suivant l'invention.

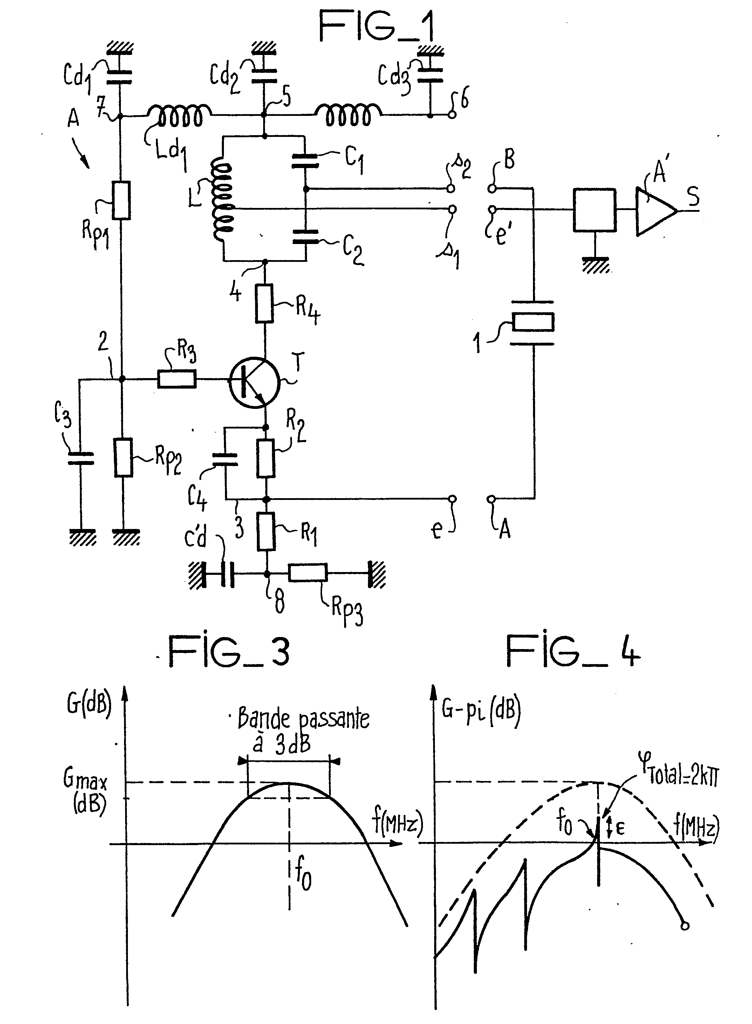

Selon la figure 1, un amplificateur A comporte un transistor T fonctionnant en base commune. Sa base est polarisée par un pont de résistances $R_{P1}$ et $R_{P2}$ par une tension d'alimentation continue V amenée à une extrémité de la résistance $R_{P1}$ (point 7). Le fonctionnement en base commune dans la bande passante de l'amplificateur est obtenu grâce à un condensateur $C_3$ disposé en parallèle sur la résistance $R_{P2}$ entre la base et la masse. Au cas ou le transitor T est susceptible de présenter en base commune une caractéristique à résistance négative, une résistance de base $R_3$ est disposée à l'entrée de la base du transistor T. C'est le cas notamment des transistors haute-fréquence du type EC, c'est-à-dire conçus pour le fonctionnement en émetteur commun, et qui présentent cette propriété lorsqu'ils sont utilisés dans un montage à base commune.

La résistance $R_3$ est branchée entre la base du transistor T et le point milieu 2 du pont de résistances ($R_{P1}$, $R_{P2}$).

L'émetteur du transistor est relié à la masse par un pont résistif constitué de deux résistances $R_2$ et $R_1$, la résistance $R_2$ étant connectée à l'émetteur, le point commun 3 aux résistances $R_1$ et $R_2$ constituant l'entrée de l'amplificateur, et l'autre extrémité de la résistance $R_1$ (point 8) étant connectée à la masse, éventuellement par l'intermédiaire d'un condensateur de découplage $C'_d$.

Le circuit du collecteur comprend successivement une résistance d'amortissement $R_4$ et un circuit parallèle du type LC comportant une première branche de type selfique L et en parallèle sur celle-ci une deuxième branche de type capacitif comportant deux condensateurs $C_2$ et $C_1$ en série. Une extrémité du condensateur $C_1$ (point 5) est reliée à l'extrémité à la self L qui est à la tension d'alimentation V et son autre extrémité au point commun aux condensateurs $C_1$ et $C_2$ qui constitue une des sorties dénommées $s_2$ de l'amplificateur. Le condensateur $C_2$ est également relié à l'autre extrémité de la self L (point 4) et à la résistance d'amortissement $R_4$. Une autre sortie de l'amplificateur $s_1$ est prise sur une des spires de la self L. Une self de valeur $L_1$ est alors présente entre le point 5 et la sortie $s_1$ et une self de valeur $L_2$ entre la sortie $s_1$ et le point 4, avec $L = L_1 + L_2$. Il va de soi que la branche selfique L peut comporter, par analogie avec la branche capacitive, deux selfs disposées en série et dont le point commun constitue alors la sortie $s_1$ de l'amplificateur. Ces selfs seront dénommées par analogie $L_1$ et $L_2$.

L'amplificateur est alimenté au point 6 par une tension continue V. Un condensateur de découplage $C_{d3}$ est disposé entre le point 6 et la masse et une self de découplage $L_{d2}$ est disposée en série entre les points 6 et le point 5, de manière à former un découplage classique LC permettant d'isoler l'amplificateur des parasites haute-fréquence. De la même façon, l'alimentation du point 7 par la tension V est réalisée avec interposition d'une self de découplage $L_{d1}$ entre les points 5 et 7. Un condensateur de découplage $C_{d2}$ est disposé entre le point 5 et la masse et un condensateur de découplage $C_{d1}$ entre le point 7 et la masse. Un découplage est réalisé également au niveau de l'émetteur où un condensateur de découplage $C'_d$ est branchée entre le point 8 et la masse. Il va de soi que ces découplages n'ont lieu d'être réalisés que si l'amplificateur risque d'être soumis à des parasites haute-fréquence. Il en résulte que, dans le cas contraire, les points 6, 7 et 8 peuvent être reliés directement à la masse.

On va maintenant montrer comment on détermine les valeurs des éléments entrant dans le schéma de l'amplificateur A. Les résistances $R_{p1}$ et $R_{p2}$ qui définissent la polarisation sont déterminées de manière classique. Leur valeur est en général égale à quelques milliers d'ohms. Le condensateur $C_3$ détermine le fonctionnement de l'amplificateur en base commune dans sa bande passante, c'est-à-dire, que dans la bande passante de l'amplificateur, l'impédance du condensateur $C_3$ doit être suffisamment faible pour que le point 2 soit pratiquement à la masse, le pont de résistance ($R_{p1}$, $R_{p2}$) continuant par ailleurs de polariser la base du transistor en continu. La valeur du condensateur $C_3$ est par conséquent d'autant plus faible que la fréquence de fonctionnement est élevée. A titre d'exemple, les valeurs de l'ordre de 10 nF conviennent à 5 mégahertz, de l'ordre de 1 nF vers 300 à 500 mégahertz. Cette valeur peut descendre à 50 pF pour les fréquences supérieures ou égales à 500 mégahertz.

La résistance $R_3$ a pour objet d'empêcher que l'impédance d'entrée du transistor T ne devienne négative. Ceci peut se produire comme expliqué plus haut avec des transistors qui présentent cette propriété lorsqu'ils sont montés en base commune. La résistance $R_3$ a en général une valeur faible par exemple inférieure à 50 ohms.

$R_2$ joue un rôle important dans la détermination du gain de l'amplificateur. Plus $R_2$ est élevée, plus le gain de l'amplificateur est faible. La résistance $R_2$ contribue également, mais à titre auxiliaire à empêcher la résistance d'entrée de l'amplificateur de devenir négative.

$R_1$ fixe l'impédance d'entrée de l'amplificateur et joue un rôle stabilisateur de cette impédance vis-à-vis des variations des paramètres extérieurs (tension d'alimentation, charge de l'amplificateur, température). Cette stabilisation est d'autant meilleure que la valeur de la résistance $R_1$ est plus faible.

Le condensateur $C_4$ branché en parallèle sur la résistance $R_2$ n'est utilisé que lorsque le gain de l'amplificateur est insuffisant. Sa valeur est très faible. Le condensateur $C_4$ permet d'abaisser en dynamique la valeur de l'impédance entre l'émetteur et le point 3 et par conséquent d'augmenter le gain de l'amplificateur, sans que toutefois l'émetteur du transistor T soit chargé par une trop faible impédance en continu. La valeur de $C_4$ est déterminée en visualisant à l'analyseur de réseau la courbe de la figure 4. L'introduction d'un condensateur $C_4$ de valeur faible permet d'élever légèrement la fonction de transfert en boucle ouverte au voisinage de $f_0$ et donc d'ajuster la valeur de $\varepsilon$ (dB) qui permet le démarrage de l'oscillateur. En pratique, on choisit $\varepsilon = 2$ à 3 dB.

La résistance $R_{p3}$ branchée en parallèle sur le condensateur de découplage $C'_d$ permet d'ajuster la consommation de l'amplificateur. Elle peut donc être supprimée si la consommation n'est pas un facteur important. La résistance $R_{p3}$ sera choisie pour obtenir une consommation minimale. Il va de soi que la résistance $R_{p3}$ coopère avec le condensateur de découplage $C'_D$ qui doit de ce fait être présente même si par ailleurs il n'est pas jugé utile de protéger l'amplificateur A contre les perturbations haute-fréquence.

Si on appelle $V_2$ la tension de base du transistor et v la chute de tension dans la jonction, il vient:

$$I = \frac{V_2 - v}{R_1 + R_2 + R_{p3}}$$

Si on impose le courant I, il vient:

$$R_{p3} = \frac{V_2 - v}{I} - (R_1 + R_2)$$

Exemple: $V = 8$ v, $R_{P1} = 10$ kΩ, $R_{P2} = 2,2$ kΩ, $R_1 = R_2 = 100$ Ω, $v = 0,6$ V on aura en l'absence de $R_{p3}$, $I = 4,2$ mA, mais pour $R_{P3} = 100$ Ω, $I = 2,8$ mA.

La valeur des éléments L, $C_1$ et $C_2$ détermine la fréquence de résonance du circuit parallèle LC disposé dans le collecteur du transistor T. Ce circuit LC présente un facteur de qualité intrinsèque qui peut être abaissé par la présence de la résistance $R_4$. $R_4$ sert donc essentiellement à amortir le circuit accordé LC et à déterminer de ce fait la largeur de la bande passante de l'amplificateur. Comme la résistance $R_4$ amortit le circuit accordé LC, elle a également pour effet de diminuer le gain de l'amplificateur A, et ce d'autant plus que sa valeur est plus élevée. En pratique la valeur de la résistance $R_2$ détermine le gain de l'amplificateur A. En effet, le facteur de qualité du circuit accordé LC et donc la valeur de la résistance $R_4$, est déterminée par la bande passante que l'on souhaite obtenir autour de la fréquence $f_0$ du circuit accordé LC.

Les sorties $s_1$ et $s_2$ étant raccordées par un pont diviseur respectivement selfique et capacitif, le gain de l'amplificateur est également dépendant du rapport de division d'impédance ainsi réalisé. Cependant, le rapport de division choisi fait également évoluer l'impédance de sortie de l'amplificateur A. Ainsi, en ce qui concerne la sortie $s_1$, l'impédance de sortie sera d'autant plus faible et le gain d'autant plus élevé que la valeur de la self résultante entre la sortie $s_1$ et le point 5 sera faible. En ce qui concerne la sortie $s_2$ l'impédance de sortie sera d'autant plus faible et le gain de l'amplificateur d'autant plus élevé que le condensateur $C_1$ aura une capacité plus élevée. Comme l'impédance de sortie de l'amplificateur A est également une donnée fixée à l'avance, le gain de l'amplificateur A est, pour cette raison également, déterminé en pratique en agissant sur la valeur de la résistance $R_2$.

L'amplificateur A peut recevoir un résonateur 1 en contre-réaction pour former un oscillateur. Cette contre-réaction peut se faire entre l'entrée e et l'une quelconque des sorties $s_1$ et $s_2$. La sortie du signal utile de l'oscillateur se fera alors de préférence par la sortie de l'amplificateur A non utilisée pour la boucle de contre-réaction de l'oscillateur.

La résistance $R_1$ sera choisie à une valeur inférieure ou égale à la résistance interne $R_i$ du résonateur 1 de manière d'une part à charger celui-ci par une impédance aussi faible que possible pour éviter la dégradation de son facteur de qualité Q et d'autre part, que l'impédance de charge soit autant que possible adaptée de manière à éviter la réflexion de l'énergie émise par la résonateur 1. Il en va de même en ce qui concerne la détermination de la valeur de l'impédance da la sortie utilisée pour la contre-réaction du résonateur 1.

Selon la figure 2, le résonateur 1 a pour schéma électrique équivalent une résistance $R_i$ en série avec un condensateur $C_i$ et une self $L_i$. Le résonateur 1 est chargé par deux résistances en série $R_c$, composante résistive de l'impédance d'entrée de l'amplificateur A et $R_s$, composante résistive de l'impédance de sortie de l'amplificateur A. De cette charge résistive, il résulte que le facteur de qualité en charge $Q_c$ du résonateur est plus faible que le facteur de qualité intrinsèque $Q_i$ déterminé par la valeur de $R_i$. L'oscillateur aura des performances d'autant meilleures que le facteur de qualité du résonateur en charge $Q_c$ sera plus élevé et plus proche de la valeur intrinsèque $Q_i$.

La figure 3 montre la courbe de réponse de l'amplificateur A sans contr-réaction. Cette courbe de réponse a un maximum de gain $G_{max}$ à la fréquence $f_0$ correspondant à la résonance du circuit LC, cette courbe s'amortissant vers les fréquences inférieures et extérieures à la fréquence $f_0$ vers des asymptotes de pente 12 décibels par octave.

La figure 4 montre en fonction de la fréquence, la différence entre le gain et la perte d'insertion de l'oscillateur. C'est le gain du système en boucle ouverte.

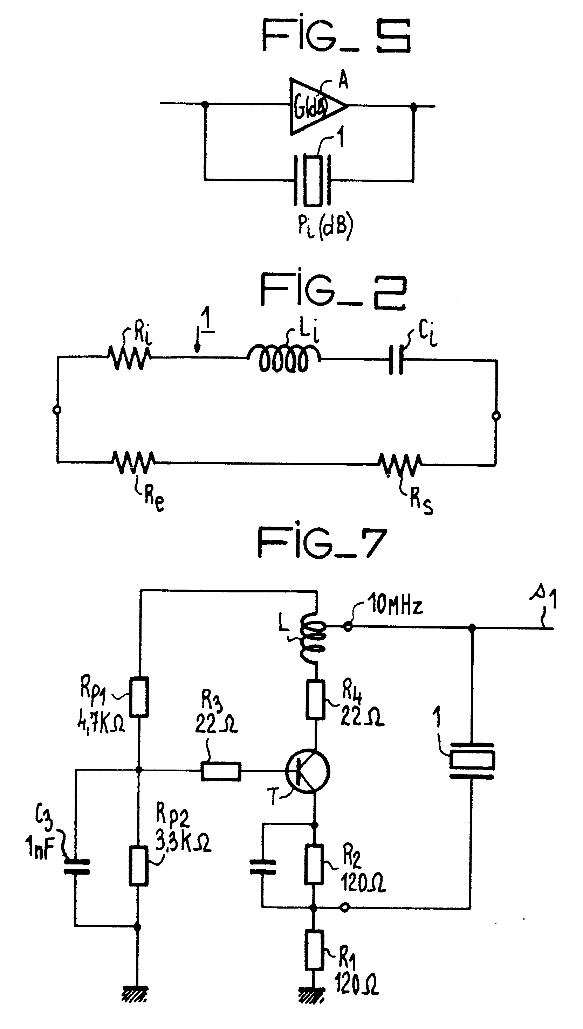

La figure 5 permet d'illustrer la condition de fonctionnement d'un oscillateur dite condition de Berkhausen. L'oscillateur se compose d'un amplificateur A présentant un gain G; entre la sortie et l'entrée de celui-ci est branché en contre-réaction un résonateur 1 présentant une perte d'insertion $P_i$. La condition de Berkhausen s'écrit: $G = P_i + \varepsilon$ (dB) où $\varepsilon$ est l'excès de gain nécessaire au démarrage de l'oscillateur. Le démarrage d'un oscillateur ne peut donc se réaliser que pour des fréquences pour lesquelles la différence $G - P_i$ est égale à $\varepsilon$. Le réseau LC étant accordé à la fréquence $f_0$ du résonateur, le gain de l'amplificateur A est ajusté de telle manière que le pic de résonance du résonateur 1 à la fréquence $f_0$ soit seul à remplir la condition de Berkhausen. De ceci résulte que le circuit accordé LC n'a pas besoin d'avoir un facteur de qualité Q élevé. Au contraire, un facteur de qualité élevé du circuit accordé LC rendrait le réglage du gain assez difficile, se traduisant par un risque de démarrage de l'oscillateur sur la fréquence du circuit accordé LC, et non sur celle précise et stable du résonateur 1. Les résonateurs ont en effet des pics de résonance de dynamique de plus en plus faible au fur et à mesure que la fréquence augmente. On cherchera donc en pratique pour faciliter les réglages à amortir le plus possible le circuit accordé LC, tout en permettant à l'amplificateur A d'avoir un gain suffisant pour que la condition de Berkhausen soit remplie.

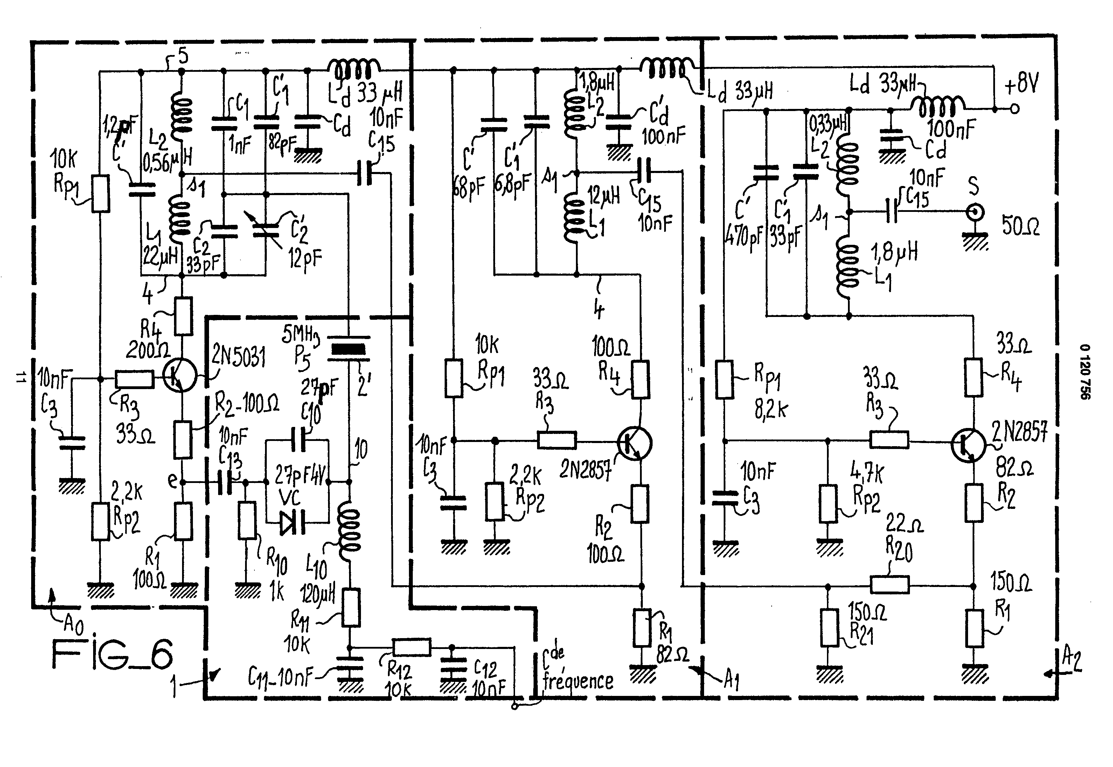

Selon la figure 6, un oscillateur et ses deux étages d'amplification associés sont constitués chacun à partir d'un amplificateur du type décrit précédemment. On a gardé les mêmes notations pour caractériser les composants correspondant au schéma de base de la figure 1. Des notations voisines ont été utilisées pour les composants disposés suivant des varaintes, notamment en ce qui concerne les circuits accordé LC pour lesquels des réseaux de configuration différente peuvent être mis en œuvre suivant les cas particuliers.

L'étage oscillateur se compose d'un amplificateur $A_0$ pour lequel on a:

$R_{P1} = 10$ kΩ, $R_{P2} = 2,2$ kΩ, $R_1 = 100$ Ω, $R_2 = 100$ Ω, $R_3 = 33$ Ω, $R_4 = 200$ Ω; $C_1 = 1$ nF, $C_2 = 33$ pF et $C_3 = 10$ nF.

Aux bornes du condensateur $C_1$ est disposé un condensateur $C'_1$ de 82 pF et aux bornes du condensateur $C_2$ est disposé un condensateur variable $C'_2$ de valeur nominale 12 pF. En outre entre les points 4 et 5 est disposée en parallèle sur les condensateurs précédents un condensateur $C'$ de 1,2 pF. Ce réseau de capacité permet un ajustement précis de la fréquence du circuit LC à la fréquence $f_0$ du résonateur 1, malgré les tolérances parfois importantes sur les valeurs réelles des capacités. Les valeurs données ci-dessus le sont donc à titre indicatif et les valeurs nominales à choisir dépendent en fait de la valeur réelle des capacités des condensateurs dans la limite des tolérances de fabrication.

Le résonateur 1 comporte un quartz 2' et un circuit de commande de fréquence à diode Varicap VC. Celle-ci a une valeur nominale de 27 pF et une tension nominale de 4 volts. En dérivation de celle-ci est disposé un condensateur $C_{10}$ de valeur de 27 pF. La diode Varicap VC est disposée en série avec le quartz 2' entre une électrode 10 de celui-ci et l'entrée de l'amplificateur $A_0$. Le circuit de commande de fréquence est alimenté par une tension continue variable présente aux bornes d'un condensateur $C_{12}$. Entre le point 10 et la masse, sont disposés successivement en série une self $L_{10}$ de 120 μH, une résistance $R_{11}$ de 10 kΩ et un condensateur $C_{11}$ de 10 nF. L'électrode non à la masse du condensateur $C_{12}$ est reliée à l'électrode non à la masse du condensateur $C_{12}$ est reliée à l'électrode non à la masse de condensateur $C_{11}$ par une résistance $R_{12}$ de 10 kΩ. D'autr part, l'électrode positive de la diode Varicap $V_C$ est reliée à la masse par une résistance $R_{10}$ de 1 kΩ et à l'entrée e de l'amplificateur $A_0$ par un condensateur $C_{13}$ de 10 nF. La sortie active $s_1$ de l'amplificateur $A_0$ de l'oscillateur est reliée à l'entrée de l'amplificateur suivant $A_1$ par un condensateur série $C_{15}$ de valeur 10 nF.

Pour l'amplificateur $A_1$, on aura $R_1 = 82$ Ω, $R_2 = 100$ Ω, $R_3 = 33$ Ω, $R_4 = 100$ Ω, $R_{P1} = 10$ kΩ, $R_{P2} = 2,2$ kΩ, $L_1 = 12$ μH, $L_2 = 1,8$ μH. La sortie $s_2$ n'étant pas utilisé dans ce montage, seuls sont connectés entre les points 4 et 5 deux condensateurs en parallèle $C'$ de valeur 68 pF et $C'_1$ de valeur 6,8 pF. La sortie $s_1$ est reliée à l'entrée de l'étage suivant $A_2$ par un condensateur $C_{15}$ de découplage valeur 10 nF. L'entrée de l'amplificateur $A_2$ s'effectue non point directement aux bornes de la résistance $R_1$ mais par l'intermédiaire d'un pont diviseur comprenant une résistance $R_{20}$ de 22 Ω et une résistance $R_{21}$ de 150 Ω dont une borne est à la masse. Pour l'étage amplificateur $A_2$, on a:

$R_1 = 150$ Ω, $R_2 = 82$ Ω, $R_3 = 33$ Ω, $R_4 = 33$ Ω, $R_{P1} = 8,2$ kΩ, $R_{P2} = 4,7$ kΩ, $L_1 = 1,8$ μH, $L_2 = 0,33$ μH, $C' = 470$ pF, $C'_1 = 33$ pF, $C_3 = 10$ nF. La sortie S de l'amplificateur $A_2$ est la sortie $s_1$.

Les selfs de découplage des différents étages $L_D$ ont une valeur de 33 μH, les condensateurs de découplage $C_D$ une valeur de 10 nF.

Selon la figure 7, le résonateur 1 a une fréquence propre 500 mégahertz. Les valeurs des composants sont alors:

$R_1 = R_2 = 120$ Ω, $R_3 = R_4 = 22$ Ω, $R_{P1} = 4,7$ kΩ, $R_{P2} = 3,3$ kΩ; $L = 10$ nH et $C_3 = 1$ nF. On notera que le réseau LC est réalisé sans adjonction d'éléments capacitifs étant donné que, à ces fréquences élevées, la capacité parasite du transistor T est suffisante (elle est de l'ordre 1 pF).

## Revendications

1. Oscillateur du type comportant un amplificateur passe-bande et un résonateur branché entre l'entrée et la sortie de l'amplificateur, l'amplificateur comportant un transistor (T) monté en base commune, l'émetteur de ce transistor étant chargé par un pont résistif dont le point milieu constitue l'entrée dudit amplificateur, le collecteur de ce transistor étant chargé par un circuit parallèle du type LC dont une extrémité est à la tension d'alimentation, caractérisé en ce qu'il peut fonctionner jusqu'à une fréquence de l'ordre de 500 MHz, l'amplificateur étant réglé de manière que la fonction de transfert en boucle ouverte remplisse les conditions de Berkhausen uniquement pour le pic de résonance du résonateur correspondant à la fréquence de résonance choisie, une résistance d'amortissement ($R_4$) reliant le collecteur du transistor audit circuit parallèle, une résistance de base ($R_3$) étant branchée entre la base du transistor et un condensateur ($C_3$) destiné à assurer le fonctionnement en base commune, la première résistance ($R_1$) et la seconde résistance ($R_2$) dudit pont résistif ainsi que les résistances de base ($R_3$) et d'amortissement ($R_4$) ayant des valeurs déterminées de façon à empêcher la résistance d'entrée de l'oscillateur de devenir négative et en fonction des résistances d'entrée et de sortie désirées pour l'amplificateur.

2. Oscillateur selon la revendication 1, caractérisé en ce que ledit circuit parallèle présentant une branche selfique et une branche capacitive, un point, dit point milieu, de la branche selfique ou de la branche capacitive constitue une sortie ($s_1$ ou $s_2$) de l'amplificateur.

3. Oscillateur selon l'une des revendications 1 ou 2, caractérisé en ce que les impédances d'entrée et de sortie de l'amplificateur sont au plus égales à la résistance série intrinsèque du résonateur.

4. Oscillateur selon l'une des revendications 1 à 3, caractérisé en ce qu'un condensateur ($C_4$) est

branché aux bornes de la deuxième résistance (R₂) du pont diviseur.

5. Oscillateur selon l'une des revendications 1 à 4, caractérisé en ce que la première résistance (R₁) du pont diviseur est reliée à la masse par un condensateur de découplage (C'd) aux bornes duquel est disposée une troisième résistance (Rp3) permettant d'optimiser la puissance consommée.

6. Oscillateur selon l'une des revendications 2 à 5, caractérisé en ce qu'une des sorties (s₁, s₂) de l'amplificateur est reliée à un circuit d'amplification présentant une impédance adaptée.

## Patentansprüche

1. Oszillator mit einem Bandpaßverstärker und einem zwischen den Ein- und Ausgang des Verstärkers geschalteten Resonator, wobei der Verstärker einen Transistor (T) in Basisschaltung aufweist, dessen Emitter mit einer Widerstandsbrücke belastet ist, deren Mittelpunkt den Eingang des Verstärkers bildet, und dessen Kollektor mit einem LC-Parallelkreis belastet ist, dessen einer Pol an der Spannungsquelle liegt, dadurch gekennzeichnet, daß der Oszillator bis zu einer Frequenz in der Größenordnung von 500 MHz arbeiten kann, wobei der Verstärker derart gesteuert wird, daß die Transferfunktionen bei offener Schleife die Berkhausen-Bedingungen nur für die Spitze der Resonatorresonanz erfüllt, die der gewählten Resonanzfrequenz entspricht; daß ein Dämpfungswiderstand (R₄) zwischen den Transistorkollektor und den Parallelkreis und ein Basiswiderstand (R₃) zwischen die Transistorbasis und einen zur Sicherstellung des Basisbetriebs dienenden Kondensator (C₃) geschaltet ist, wobei der erste Widerstand (R₁) und der zweite Widerstand (R₂) der Widerstandsbrücke sowie der Basiswiderstand (R₃) und der Dämpfungswiderstand (R₄) Werte besitzen, die ein Negativwerden des Eingangswiderstands des Oszillators verhindern und die von den für den Verstärker gewünschten Ein- und Ausgangswiderständen abhängen.

2. Oszillator nach Anspruch 1, dadurch gekennzeichnet, daß der Parallelkreis einen induktiven und einen kapazitiven Zweig besitzt, wobei ein Punkt, Mittelpunkt genannt, des induktiven oder des kapazitiven Zweiges einen Verstärkerausgang (s₁ oder s₂) bildet.

3. Oszillator nach einem der Ansprüche 1 oder 2, dadurch gekennzeichnet, daß die Ein- und Ausgangsimpedanzen des Verstärkers höchstens genauso groß wie der Reiheninnenwiderstand des Resonators sind.

4. Oszillator nach einem der Ansprüche 1 bis 3, dadurch gekennzeichnet, daß ein Kondensator (C₄) zwischen die Anschlußklemmen des zweiten Widerstands (R₂) der Teilungsbrücke geschaltet ist.

5. Oszillator nach einem der Ansprüche 1 bis 4, dadurch gekennzeichnet, daß der erste Widerstand (R₁) der Teilungsbrücke über einen Entkopplungskondensator (C'd) an Masse gelegt ist, an dessen Anschlußklemmen ein dritter Widerstand (Rp3) angeschlossen ist, welcher den Leistungsverbrauch optimiert.

6. Oszillator nach einem der Ansprüche 2 bis 5, dadurch gekennzeichnet, daß einer der Ausgänge (s₁, s₂) des Verstärkers an einen Verstärkerkreis angeschlossen ist, der eine adaptierte Impedanz besitzt.

## Claims

1. An oscillator comprising a band-pass amplifier and a resonator branched to the input and the output of the amplifier, the latter comprising a common base transistor (T), the emitter of which is connected to a load resistor bridge having an intermediate point constituting the input of the amplifier, whereas the collector of the transistor is charged by a LC-type parallel circuit, one terminal of which is connected to the feed voltage, characterized in that the oscillator is able to operate up to a frequency of about 500 MHz, the amplifier being controlled in such a manner that the transfer function in the open-loop mode satisfies the Berkhausen conditions only as to the resonance peak of the resonator corresponding to the chosen resonance frequency, a damping resistor (R₄) being disposed to connect the collector of the transistor with the said parallel circuit, while a base resistor (R₃) is branched between the transistor base and a capacitor (C₃) provided for ensuring the common base mode operation, the values of the first resistor (R₁) and the second resistor (R₂) of the said resistor bridge as well as of the base resistor (R₃) and the damping resistor (R₄) being chosen such that the input resistance of the oscillator is prevented from becoming negative, and being chosen in accordance with the desired input and output resistances of the amplifier.

2. An oscillator according to claim 1, characterized in that, the parallel circuit comprising an inductive branch and a capacitative branch, a point referred to as intermediate point of the inductive or of the capacitative branch constitutes an output (s₁ or s₂) of the amplifier.

3. An oscillator according to one of claims 1 or 2, characterized in that the input and output impedances of the amplifier are at most equal to the intrinsic serial resistance of the resonator.

4. An oscillator according to one of the claims 1 to 3, characterized in that a capacitor (C₄) is connected to the terminals of the second resistor (R₂) of the divider bridge.

5. An oscillator according to one of the claims 1 to 4, characterized in that the first resistor (R₁) of the divider bridge is connected to ground via an uncoupling capacitor (C'd), to the terminals of which is connected a third resistor (Rp3) ensuring an optimum power consumption.

6. An oscillator according to one of the claims 2 to 5, characterized in that one of the outputs (s₁, s₂) of the amplifier is connected to an amplification circuit presenting a matched impedance.

# FIG_1

# FIG_3

# FIG_4

## FIG_5

## FIG_2

## FIG_7

FIG_6

0 120 756